Europäisches Patentamt

European Patent Office

Office européen des brevets

(19)

(11) Numéro de publication : **0 002 409**
**B1**

(12) # FASCICULE DE BREVET EUROPÉEN

(45) Date de publication du fascicule du brevet :
13.01.82

(51) Int. Cl.³ : **H 01 J 37/30**

(21) Numéro de dépôt : **78400194.3**

(22) Date de dépôt : **21.11.78**

---

(54) **Dispositif permettant le dessin programmé de figures de formes différentes par bombardement d'une cible par un faisceau de particules.**

(30) Priorité : **22.11.77 FR 7735040**

(43) Date de publication de la demande :
**13.06.79 (Bulletin 79/12)**

(45) Mention de la délivrance du brevet :
**13.01.82 Bulletin 82/02**

(84) Etats contractants désignés :
**DE GB NL**

(56) Documents cités :
**IEEE TRANSACTIONS ON ELECTRON DEVICES,**
vol. ED-22, no 7, juillet 1975, pages 385-392
**D.R. HERRIOT et al. : « EBES : A Practical Electron Lithographic System ».**
**THE JOURNAL OF VACUUM SCIENCE AND TECHNOLOGY, vol. 12, no. 6, nov./dec. 1975, pages 1 252-1 256 ; New York USA**
**D.S. ALLES et al. : « Control system design and alignment methods for electron lithography ».**

(73) Titulaire : **THOMSON-CSF**
**173, Boulevard Haussmann**
**F-75360 Paris Cedex 08 (FR)**

(72) Inventeur : **Trotel, Jacques**
**"THOMSON-CSF" -SCPI 173, bld Haussmann**
**F-75360 Paris Cedex 08 (FR)**

(74) Mandataire : **Lepercque, Jean et al**
**"THOMSON-CSF" - SCPI 173, Bld. Haussmann**
**F-75360 Paris Cedex 08 (FR)**

---

Imprimerie Jouve, 18, rue St-Denis, 75001 Paris, France

## Dispositif permettant le dessin programmé de figures de formes différentes par bombardement d'une cible par un faisceau de particules

L'invention a pour objet un dispositif permettant le dessin programmé de figures de formes différentes.

De tels dispositifs sont utilisés dans la production de circuits intégrés. On sait que les circuits intégrés comportent des composants de nature différente, et sont constitués de substrats semiconducteurs sur lesquels sont intégrées des zones de type de conductivité n et p et des contacts ohmiques. Ces produits sont fabriqués par diffusion ou implantation à travers des masques de résines sensibles ou aux électrons ou aux radiations lumineuses. Ces masques peuvent être obtenus par des dispositifs d'optique classique ou électronique, capables d'effectuer sous l'action de signaux électriques engendrés par des convertisseurs numériques analogiques, euxmêmes reliés aux sorties d'un ordinateur, des tracés de figures programmées, sur un support sensible à l'impact du faisceau.

Les systèmes de tracé de masques par bombardement par faisceau électronique doivent en général satisfaire aux conditions typiques suivantes :

— le dessin à tracer a une dimension de 100 mm × 100 mm environ ;

— la définition du tracé est de 0,1 μm environ ;

— la précision du tracé, c'est-à-dire l'écart entre la position théorique d'un point et sa position réelle est de 0,1 μm environ.

La précision relative du tracé (0,1 μm sur 100 mm) est donc de $10^{-6}$ environ ce qui veut dire que la position relative du faisceau électronique et de l'échantillon doit être définie avec une précision relative de $10^{-6}$.

Dans l'état actuel de la technique on ne sait pas commander la position d'un faisceau électronique avec une telle précision, aussi les systèmes de tracé de masques par faisceau électronique emploient, pour définir la position relative de l'échantillon et du faisceau la superposition de deux mouvements :

1. Un déplacement mécanique de l'échantillon par rapport à la colonne d'optique électronique formant le faisceau : ce déplacement peut se faire sur une étendue supérieure aux dimensions du dessin à réaliser, soit 100 mm × 100 mm pour l'exemple choisi, et se fait avec une précision meilleure que la précision du dessin, soit 0,1 μm pour cet exemple.

Pour réaliser ce déplacement de l'échantillon on emploie par exemple les techniques de mesure des déplacements par interférométrie, ou d'autres techniques connues.

2. Un déplacement du faisceau électronique par rapport à la colonne d'optique électronique qui le produit. Ce déplacement se fait par les techniques connues de déflexion électromagnétique ou électrostatique des faisceaux électroniques.

Ce déplacement se fait avec une précision absolue meilleure que la précision du dessin soit 0,1 μm pour notre exemple, et sur une étendue faible par rapport à la dimension du dessin, par exemple sur 1 mm × 1 mm.

La façon dont sont combinés ces deux déplacements pour tracer le dessin en un temps le plus réduit possible est très variable dans les différents systèmes qui ont été construits.

Le dispositif selon l'invention emploie une combinaison qui permet de réduire le temps de tracé dans certains cas d'intérêt pratique.

Les principales combinaisons de déplacements mécanique et électronique employées dans l'art antérieur sont les suivantes :

1. Déplacement mécanique continu dans deux directions orthogonales X et Y combiné avec un déplacement électronique dans deux directions.

Dans cette disposition le tracé ne se fait que lorsque l'échantillon est immobile par rapport à la colonne d'optique électronique. Il apparaît donc que le temps pendant lequel l'échantillon se déplace est entièrement perdu puisque aucun tracé ne se fait pendant cette période. Cet inconvénient ne devient sensible que lorsque le temps de déplacement mécanique sur une distance égale à l'amplitude maximale de déflexion du faisceau n'est pas négligeable par rapport au temps que met le faisceau pour faire un tracé sur une étendue égale à l'étendue sur laquelle le faisceau peut être défléchi.

Dans les systèmes habituels cette condition est effectivement remplie puisque le temps de déplacement mécanique est de 0,1 s à 1 s typiquement alors que le temps de tracé sur une étendue correspondant à l'étendue maximale de déflexion du faisceau est de 1 s à 10 s typiquement.

Mais, cette condition n'est pas satisfaite pour un dispositif tel que celui décrit dans la demande française de brevet N° 76 14 719 au nom de la demanderesse et publiée sous le N° 2 351 497 où le temps de tracé sur une étendue correspondant à l'étendue maximale de déflexion du faisceau peut être de $10^{-3}$ s à $10^{-1}$ s typiquement.

2. Déplacement mécanique continu dans une direction Y et discontinu dans une direction orthogonale X, combiné à un déplacement électronique dans la direction X. Il n'y a pas de déplacement électronique dans la direction Y, sauf éventuellement un faible déplacement utilisé pour diverses corrections.

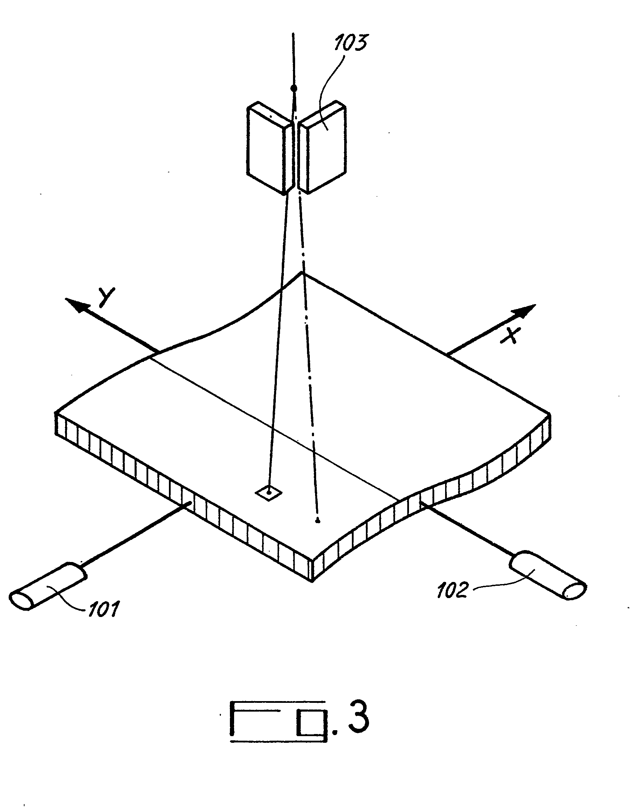

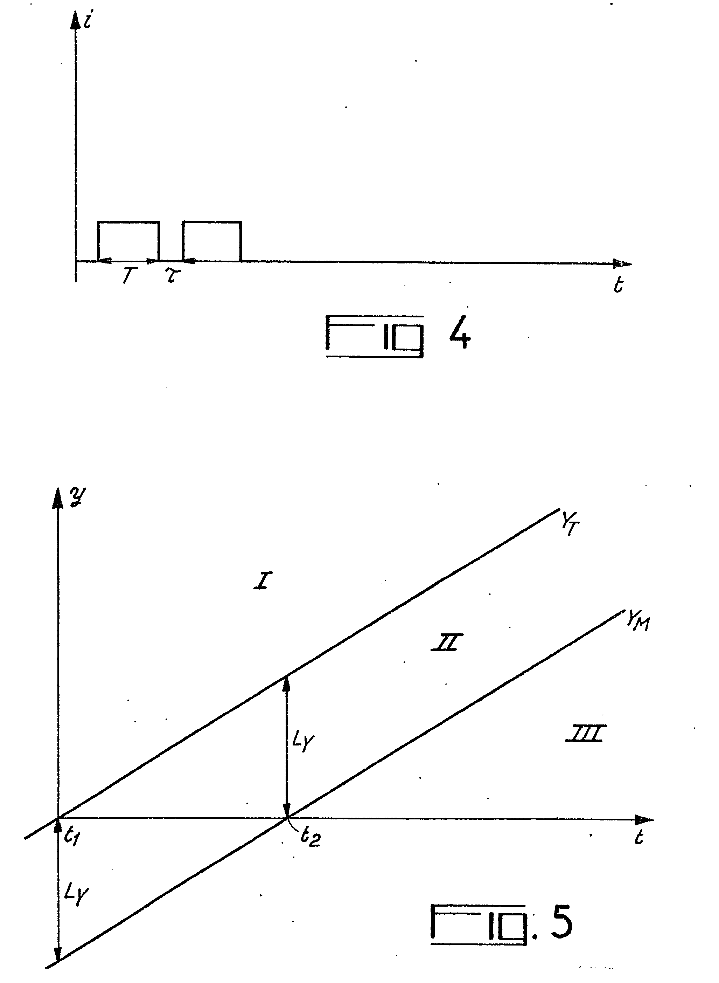

Un tel dispositif est décrit par exemple, dans l'article de HERRIOTT et al. : « EBES : A Practical Electron Lithographic System » paru dans « IEEE TRANSACTIONS ON ELECTRON DEVICES », volume ED-22, N° 7, juillet 1975, pages 385-392 ; plus particulièrement en référence aux figures 3 et 4 et au texte associé à ces figures.

Dans ces systèmes le tracé se fait pendant le déplacement de l'échantillon en Y, il n'est interrompu que pendant les déplacements en X. Il n'y a donc que peu de temps perdu mais il est difficile d'envisager ce mode d'inscription pour utiliser efficacement un système tel que celui décrit dans la demande de brevet français précitée.

Le dispositif selon l'invention permet le dessin programmé sur une cible de figures de formes différentes composées d'images élémentaires de formes variables, par bombardement de la cible par un faisceau de particules.

L'invention a donc pour objet un dispositif permettant le dessin programmé de figures de formes différentes par bombardement d'une cible par un faisceau de particules de section ajustable produit par une source de particule fixe, les figures étant composées d'images élémentaires de formes variables associées chacune à un point repère identifiable par un couple d'adresses d'abscisse et d'ordonnée dans un système d'axes de références orthogonaux ; dispositif comportant un moteur pas à pas assurant un déplacement de la cible suivant une première direction parallèle à l'axe des abscisses, de façon à soumettre à l'impact du faisceau de particules successivement des portions de la cible pendant les intervalles de temps où elle est immobile suivant cette direction, et un moteur assurant un déplacement continu de la cible suivant une seconde direction parallèle à l'axe des ordonnées ; dispositif principalement caractérisé en ce qu'il comprend des moyens de balayage électronique pour défléchir le faisceau de particules de façon à annuler le mouvement relatif du faisceau par rapport à la cible suivant la seconde direction pendant un temps au moins égal au temps nécessaire à l'inscription d'au moins une image élémentaire dont le point repère a une adresse d'ordonnée déterminée.

L'invention sera mieux comprise au moyen de la description ci-après en se référant aux dessins annexés parmi lesquels :

la figure 1 représente très schématiquement un ensemble électronique pour la fabrication de masques tel que décrit dans la demande de brevet déposée en France, sous le N° 76 14 719 pour « Dispositif permettant le tracé programmé de figures de formes différentes », et est en fait la figure 5 de cette demande ;

la figure 2 est une reproduction de la figure 4 de cette demande ;

la figure 3 représente très schématiquement le système de balayage du dispositif selon l'invention ;

les figures 4, 5 et 6 sont des courbes explicatives ;

la figure 7 est un exemple de réalisation du système logique permettant de faire fonctionner le dispositif selon l'invention.

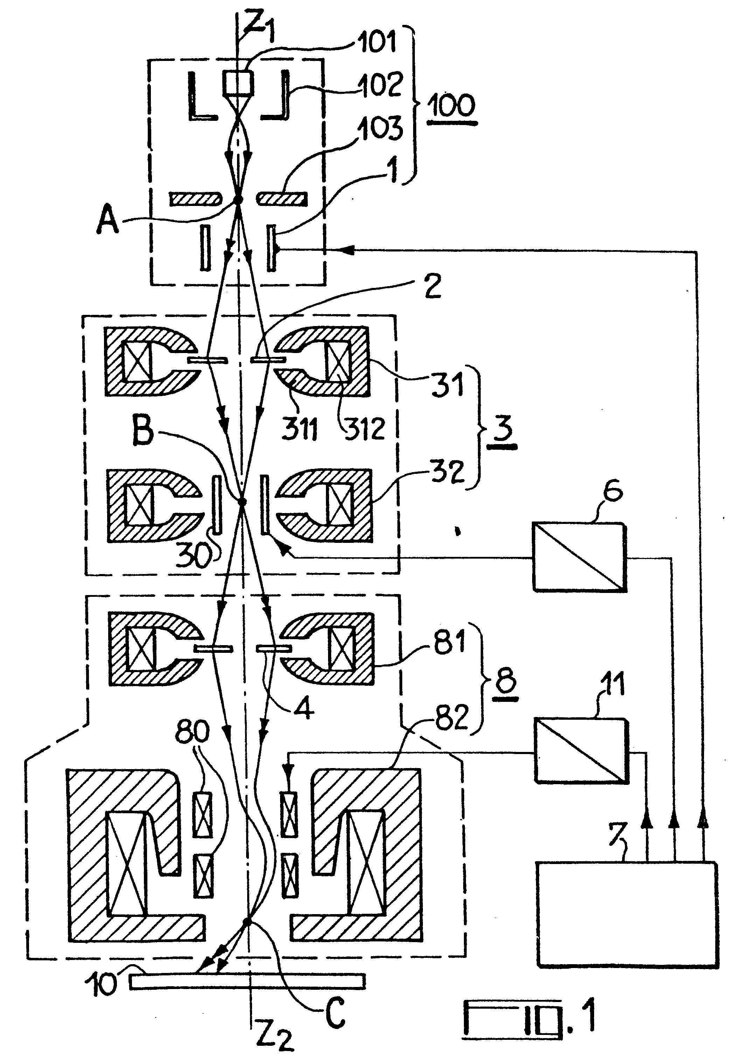

En se reportant à la demande citée, la figure 5 qui est reproduite sur la figure 1, on voit un canon électronique 100 formant d'une cathode 101 une image ponctuelle A. En aval est placé un diaphragme 2. Un dispositif d'effacement 1 permet de dévier le faisceau hors du diaphragme 2.

Ce diaphragme 2, placé en aval est placé au centre d'une lentille électromagnétique 31 qui, associée avec une autre lentille du même type 32, constitue l'ensemble 3. La lentille 31 comme expliqué dans la demande donne du point A une image B au niveau de la lentille 32. L'ensemble avec un grandissement − 1, forme du diaphragme une image réelle dans le plan d'un autre diaphragme 4. Cette image peut se déplacer par action sur le système de déflexion 30 ; la lentille 81 ayant sa pupille d'entrée dans le plan du diaphragme 4 donne du point B une image C située à la hauteur du centre de déflexion du système de déflexion 80.

L'ensemble 81-82 forme du diaphragme 4 et de l'image réelle du diaphragme 2, une image située dans le plan de l'objet 10.

Un calculateur 7 commande d'une part l'électrode 1 d'effacement, d'autre part par l'intermédiaire de transducteurs numériques analogiques 6 et 11, le système de déflexion 30 (qui donne la forme définitive du faisceau) et 80 qui déterminent la zone d'impact du faisceau ainsi délimité sur la cible.

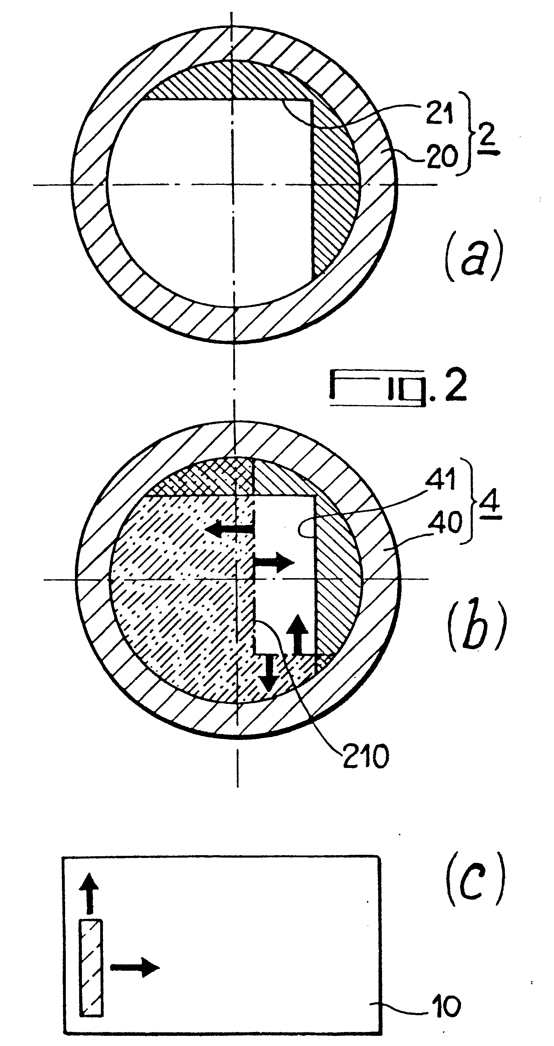

La figure 2 qui est la figure 4 de la demande de brevet citée montre les étapes successives de la production d'une image de forme déterminée. Chaque image est donc déterminée par sa position sur la cible, c'est-à-dire son adresse (coordonnées rapportées à deux axes rectangulaires liés à la cible), et par sa forme, déterminée par les tensions de déflexion appliquées au système de déflexion 30.

Tel que représenté, dans ce système la cible est fixe et l'adressage se fait par action sur le dispositif de déflexion 80. Il en résulte les inconvénients signalés plus haut.

La présente invention a pour objet un dispositif dans lequel, le déplacement de la cible en X se fait grâce à un moteur 101 « pas à pas », ce qui permet de bombarder la cible par pages successives (figure 3), un moteur 102 assurant un déplacement en Y continu.

Sur la figure 3, on voit également les systèmes de déflexion 103, assurant les déflexions du faisceau dans les conditions prévues par l'invention.

Sur la figure 4 est représenté le signal appliqué à l'électrode d'effacement du faisceau pour le tracé d'une image élémentaire. On voit qu'il faut un temps fixe $T$ pour que le faisceau, allumé, trace une image telle que celle de la figure 2 quelle que soit sa dimension. Ce temps est nécessaire en particulier pour impressionner une résine. Un temps minimum $\tau$, dû aux paramètres de l'appareil est nécessaire pour passer d'une image à la suivante.

La figure 5 représente l'axe $Y_T$ décrit par le point de repos du faisceau, sur l'échantillon celui-ci étant considéré comme immobile, et l'axe de l'optique électronique étant supposé se déplacer, c'est-à-dire le contraire de ce qui est le cas.

Le faisceau est supposé pouvoir être défléchi au maximum d'une longueur $L_Y$, dans la direction OY. Il en résulte que le point de déflexion maximal décrit la droite $Y_M$ parallèle à $Y_T$, dans les mêmes conditions que le point de repos. Il est bien entendu que ce qui est représenté est la cible elle-même et que l'axe de référence OY est lié à la cible, l'axe perpendiculaire étant l'axe des temps.

Quand, à une adresse déterminée, une figure, un rectangle par exemple, doit être tracé, le faisceau est défléchi de façon à ce que sa position Y par rapport à la cible reste fixe, ce qui est une caractéristique essentielle de l'invention. Il en résulte que le temps maximum d'inscription disponible à une adresse déterminée Y est le temps $t_2 - t_1$, temps qui dépend de $L_y$, $L_y$ étant la déflexion maximale du faisceau en Y, et de la pente V de la courbe $Y_T$, qui est la vitesse de déplacement du point de repos du faisceau par rapport à la table, c'est-à-dire au signe près à la vitesse de déplacement de la table en Y par rapport au système d'optique électronique. Il est évident que pour une même valeur $L_y$ plus V est grand et plus $t_2 - t_1$ est petit. Le nombre maximum de figures inscriptible à l'ordonnée Y est donc $N = \dfrac{t_2 - t_1}{T + \tau}$.

A titre d'exemple, on supposera dans ce qui suit que N = 3.

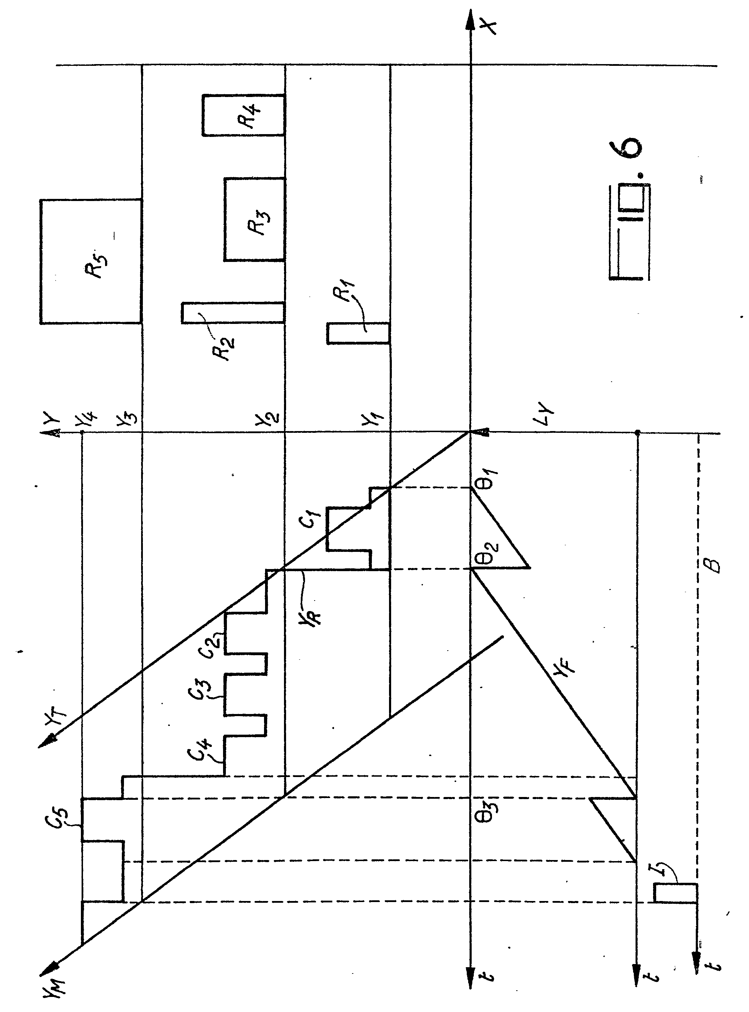

La figure 6, représente sur sa partie droite, l'échantillon à bombarder considéré comme fixe.

En haut à gauche sont représentés, toujours par rapport à un axe OY lié à l'échantillon, la courbe $Y_T$ de la figure précédente, l'échelle des temps croissants étant disposée à l'inverse de la figure précédente, et la courbe $Y_M$. Est représentée en plus la courbe $Y_F$ de déplacement du faisceau, nécessaire pour inscrire sur l'échantillon, un certain nombre de rectangles $R_1$ à $R_5$, aux adresses en Y, $Y_1$, $Y_2$ et $Y_3$ toujours rapportée aux mêmes axes.

A l'adresse $Y_1$, doit être tracé un rectangle unique $R_1$ dont l'abscisse $X_1$ du sommet inférieur de gauche sur la figure, ainsi que la largeur 1, et la hauteur h sont fournis par le calculateur au temps $\theta_1$. Le faisceau doit rester à cette adresse pendant le temps $T + \tau$ (créneau représenté en $C_1$), qui on le rappelle une fois de plus ne dépend pas de la forme du rectangle. Au temps $\theta_2$, le faisceau doit atteindre l'adresse $Y_2$ où doivent être formés trois rectangles $R_2$, $R_3$, $R_4$, nombre maximum de rectangles par lignes. Il en résulte que le faisceau doit prendre son état de repos au temps $\theta_2$, c'est-à-dire revenir sur la courbe $Y_T$. Il en résulte qu'il doit au temps $\theta_2$ passer brusquement, c'est-à-dire par un mouvement discontinu vertical à la ligne $Y_T$. Il décrit de, $\theta_2$ à $\theta_3$, la ligne horizontale $Y_2$, pendant le temps nécessaire à l'inscription des rectangles $R_2$, $R_3$, $R_4$. La séquence des créneaux $C_2$, $C_3$, $C_4$ chacun correspondant à un rectangle $R_2$, $R_3$, $R_4$ occupe tout l'intervalle de temps $\theta_3 - \theta_2$. On voit donc que pour inscrire le maximum de figures par ligne, ici trois, le point d'impact du faisceau doit nécessairement partir de la droite $Y_T$. Il ne pourra alors inscrire des figures à une ligne $Y_3$, que si au temps $\theta$, l'ordonnée $Y_3$ se situe au-dessus de la courbe $Y_M$ d'une part, et que d'autre part il reste à cette ordonnée un intervalle de temps suffisant pour inscrire au moins une figure c'est-à-dire un intervalle supérieur à $T + \tau$. C'est le cas pour le

rectangle $R_5$ auquel correspond le créneau $C_5$.

On voit ainsi clairement que l'intervalle $\dfrac{t_2 - t_1}{T + \tau}$ est une limitation à la densité d'inscription.

Les créneaux $C_1$ à $C_5$ sont représentés au-dessus des parties correspondantes de la courbe $Y_R$. On voit ainsi clairement les séquences d'allumage et d'extinction du faisceau.

La partie inférieure de la figure représente, rapportée à des axes liés à l'optique électronique et non plus à l'échantillon, les séquences de déflexion, du faisceau $Y_F$ en fonction de la même échelle de temps. Les parties inclinées ont la même pente que la courbe $Y_T$ en valeur absolue, mais opposée en signe. A chaque palier de la courbe $Y_R$, correspond une rampe de la courbe $Y_F$, ce qui montre que pendant les inscriptions le faisceau se déplace, et suit dans son déplacement l'échantillon jusqu'à ce que la déflexion atteigne la valeur maximale Ly.

Si à une adresse $Y_4$, le temps disponible est inférieur à $T + \tau$, une impulsion I est envoyée au calculateur.

Bien entendu, la vitesse V peut être constante, ou au contraire, varier de façon à ralentir l'échantillon, quand la densité d'images à tracer est forte, et à l'accélérer dans le cas contraire.

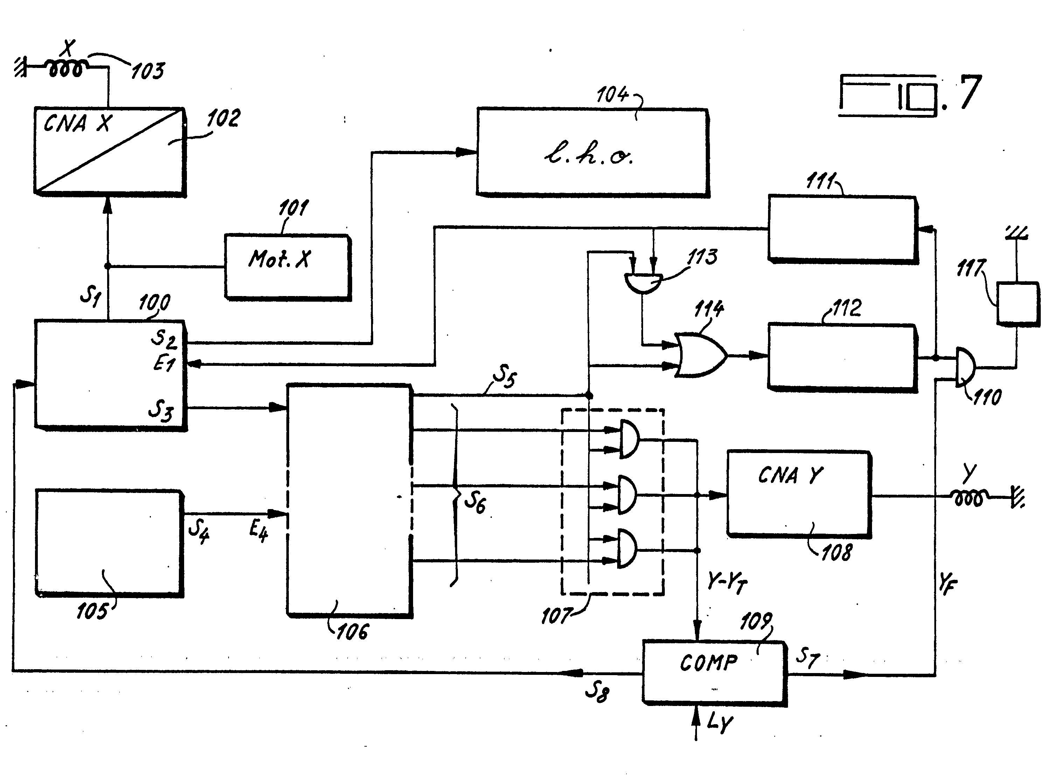

Le circuit de la figure 7 permet d'assurer ces opérations.

Le circuit comprend un calculateur 100 comportant plusieurs sorties. La sortie $S_1$ commande le moteur 101 de déplacement en x qui est un moteur pas à pas permettant de passer d'une page de l'objet à impressionner à la suivante. Elle commande également le convertisseur numérique-analogique 102 qui commande le système de déflexion en X 103.

Le moteur qui assure le déplacement en Y et qui a une vitesse de rotation uniforme n'est pas représenté. La sortie $S_2$ donne à chaque adresse, à un modulateur 104 de forme du faisceau, les indications I, longueur du rectangle, h, hauteur et $\theta$ inclinaison des côtés sur les axes de référence, éventuellement.

La sortie $S_3$ fournit les adresses Y. Ces adresses sont des nombres à plusieurs chiffres en numération binaire. Cette sortie est donc une sortie composée d'éléments logiques en nombre égal à ceux des chiffres.

Un interféromètre 105 fournit à chaque instant la position réelle $Y_T$ du porte-objet. Cet interféromètre comporte un compteur dont les sorties $S_4$ sont couplées aux entrées $E_4$ d'un soustracteur 106, qui est couplé également à la sortie $S_3$ du calculateur.

Le soustracteur 106 a une sortie $S_5$ qui prend l'état « 0 » tant que l'inégalité $|Y - Y_T| > 0$ est respectée et l'état « 1 » dans le cas contraire. Cette sortie est couplée en parallèle sur les n entrées de n portes ET 107.

Ces n circuits ET ont leurs deuxièmes entrées respectives couplées à un ensemble de n sortie $S_6$ à deux états dont la combinaison forme un nombre en numération binaire.

Quand ces portes sont ouvertes par la sor-

tie $S_5$, elles délivrent à leurs sorties respectives le nombre affiché par le soustracteur 106, à un convertisseur digital analogique 108 qui délivre son signal de sortie au système de déflexion en Y et engendre la succession de rampes $Y_F$ de la figure 6. Un comparateur 109 reçoit d'une part sur ses deux entrées les chiffres sortant du circuit 107 et le nombre correspondant à Ly.

Ce comparateur a une sortie $S_7$ qui se met à l'état « 1 » si $|Y_F| < Ly$ et à l'état « 0 » dans le cas contraire et une sortie $S_8$, donnant le signal complémentaire. A l'état « 1 » il ouvre une porte ET 110 dont la sortie est connectée à la commande d'effacement du faisceau 117.

L'autre entrée de la porte ET est reliée à deux monostables 111 et 112, chacun de ces monostables revenant à son état stable après un temps T ou $\tau$, correspondant respectivement au temps d'allumage du faisceau pour engendrer une image et au temps minimum séparant deux allumages ; le monostable 112 est déclenché par deux circuits ET 113, et OU 114, et déclenche à son tour le monostable 111.

Le circuit OU 114 a une entrée connectée à la sortie $S_5$ et l'autre à la sortie du circuit ET 113, connectée à la sortie $S_5$ et à celle du monostable 112, qui se reboucle sur une entrée $E_1$ du calculateur.

Le fonctionnement de l'ensemble est le suivant : Au point de vue du balayage en X, celui-ci est commandé par la sortie $S_1$ du calculateur, dont la sortie $S_2$ commande la forme du faisceau par le circuit 104.

L'ensemble comporte deux parties distinctes, à savoir celle qui commande l'allumage et l'effacement du faisceau, et celle qui assure le balayage en Y. On va examiner successivement les deux fonctions :

Le calculateur fixe l'adresse Y. L'interféromètre a un compteur qui affiche à cet instant l'ordonnée réelle de la table. L'organe 106 effectue la différence $Y - Y_T$. Sa première sortie $S_5$ est à l'état « 1 », si $Y - Y_T < 0$, à l'état « 0 » dans le cas contraire. A l'état « 1 », elle ouvre toutes les portes ET du circuit 107.

Les sorties du circuit 107 ont des états qui correspondent respectivement aux sorties du circuit 106 et leur combinaison donne le nombre $Y - Y_T$. Or on sait que si $Y - Y_T < Ly$ valeur fixe, le balayage en Y doit entrer en action. A cet effet, le comparateur 109 compare $Y - Y_T$ avec Ly.

Ses deux entrées reçoivent donc respectivement ces deux données. Si $(Y - Y_T) < Ly$, la sortie $S_7$ sortie de droite du comparateur est à l'état 1. Elle ouvre la porte 110.

Le monostable 112 par l'intermédiaire de la sortie $S_5$ et du circuit OU 114 s'est mis dans l'état 1. La porte 110 est ouverte. Le faisceau est allumé. Au bout du temps T le monostable 112 se remet à 0 et envoie une impulsion au monostable — 111 qui se met à l'état « 1 » pendant le temps $\tau$. Le faisceau est éteint.

A la fin du temps $\tau$, le monostable 111 se remet à l'état « 0 » et envoie une impulsion sur la porte 115. Si la sortie $S_5$ est à l'état 1, le monostable 112 se remet à l'état « 1 », et le cycle recommence. Le faisceau se rallume etc...

Si la sortie $S_5$ se met à l'état 0, la porte 110 reste fermée et le faisceau est éteint.

## Revendications

1. Dispositif permettant le dessin programmé de figures de formes différentes par bombardement d'une cible par un faisceau de particules de section ajustable produit par une source de particules (100), les figures étant composées d'images élémentaires ($R_1$ à $R_5$) de formes variables associées chacune à un point repère identifiable par un couple d'adresses d'abscisse et d'ordonnée dans un système d'axes de références orthogonaux (OXY) ; dispositif comportant un moteur pas à pas (101) assurant un déplacement de la cible suivant une première direction parallèle à l'axe des abscisses (OX), de façon à soumettre à l'impact du faisceau de particules successivement des portions de la cible pendant les intervalles de temps où elle est immobile suivant cette direction, et un moteur (102) assurant un déplacement continu de la cible suivant une seconde direction parallèle à l'axe des ordonnées (OY) ; dispositif caractérisé en ce qu'il comprend des moyens de balayage électronique pour défléchir le faisceau de particules de façon à annuler le mouvement relatif du faisceau par rapport à la cible suivant la seconde direction (OY) pendant un temps $(\theta_3 - \theta_2)$ au moins égal au temps nécessaire à l'inscription d'au moins une image élémentaire ($R_2$, $R_3$, $R_4$) dont le point repère a une adresse d'ordonnée ($Y_2$) déterminée.

2. Dispositif suivant la revendication 1, caractérisé en ce que les particules sont des électrons.

3. Dispositif suivant la revendication 2, caractérisé en ce que des moyens à commande électrique (2, 4) sont prévus pour déterminer la section ajustable du faisceau de façon à l'adapter à la forme de l'image élémentaire à inscrire, et pour déterminer sa zone d'impact sur la cible (10) et former ainsi à chaque impact une image élémentaire.

4. Dispositif suivant la revendication 2, caractérisé en ce qu'un calculateur assure le déroulement du programme, ce calculateur ayant une première ($S_3$) et une deuxième ($S_2$) sortie délivrant respectivement les adresses d'ordonnée des points repères de chacune des images élémentaires et un ensemble de chiffres (I, h, $\theta$) définissant la forme de chaque image élémentaire, un premier et un deuxième transducteur digital analogique (CNAX, CNAY) transformant ces chiffres en signaux électriques appliqués aux moyens de commande du faisceau (X, Y).

5. Dispositif suivant la revendication 4, caractérisé en ce qu'un ensemble de dispositifs monostables (111, 112) assure l'allumage et l'extinction du faisceau entre l'inscription de deux images élémentaires, la période d'allumage (T) étant constante quelles que soient les dimensions de l'image élémentaire à tracer, et chaque période d'extinction étant le multiple entier d'un temps prédéterminé, qui est le temps minimal (τ), pour passer d'une période d'allumage à la suivante.

6. Dispositif suivant la revendication 5, caractérisé en ce que l'amplitude de la déflexion du faisceau suivant la seconde direction (OY) pouvant être au plus égale à une valeur prédéterminée ($L_Y$), des moyens de comparaison (109) produisent un premier signal ($S_7$) lorsque la différence ($Y - Y_T$) entre l'adresse d'ordonnée (Y) du point repère associé à la prochaine image élémentaire à inscrire et la position ($Y_T$) de la cible suivant la seconde direction (OY) par rapport à une référence fixe liée à la source produisant le faisceau, est inférieure à la valeur prédéterminée ($L_Y$) et un second signal ($S_8$) complémentaire au premier signal lorsque la différence est supérieure à cette valeur.

**Claims**

1. Device permitting the programmed design of figures of different shapes by bombardment of a target by a particle beam of adjustable section produced by a particle source (100), the figures being composed of elementary images ($R_1$ to $R_5$) of variable shapes each associated with one reference point which may be identified by a couple of abscissa and ordinate addresses in a perpendicular reference axis system (OXY) ; the device comprising a step motor (101) assuring a displacement of the target along a first direction parallel to the abscissa axis (OX) in order to successively expose portions of the target to the particle beam during time intervals where it is stationary in this direction, and a motor (102) assuring a continuous displacement of the target along a second direction parallel to the ordinate axis (OY) ; the device being characterized in that it comprises electronic scanning means for deflecting the particle beam in a manner to cancel the relative movement of the beam with respect to the target in the second direction (OY) during a time ($\theta_3 - \theta_2$) at least the same as the time necessary for marking at least one elementary image ($R_2$, $R_3$, $R_4$) the reference point of which has a determined ordinate address ($Y_2$).

2. Device in accordance with claim 1, characterized in that the particles are electrons.

3. Device in accordance with claim 2, characterized in that electric control means (2, 4) are provided to determine the adjustable section of the beam in a manner to adapt the same to the shape of the elementary image to be marked, and to determine the impact zone on the target (10) for thus producing one elementary image upon each impact.

4. Device in accordance with claim 2, characterized in that a calculator assures the progress of the program, this calculator having a first ($S_3$) and a second ($S_2$) output respectively delivering the ordinate addresses of the reference points of each of the elementary images and a group of

numbers (l, h, θ) defining the form of each elementary image, a first and a second digitalanalog converter (CNAX, CNAY) transforming these numbers into electric signals applied to the control means of the beam (X, Y).

5. Device in accordance with claim 4, characterized in that a group of monostable devices (111, 112) assures the switching on and off of the beam between the marking of two elementary images, the on-period (T) being constant independent of the dimensions of the elementary image to be marked, and each off-period being an integral multiple of a predetermined time which is the minimum time (τ) for passing from one on-period to the following.

6. Device in accordance with claim 5, characterized in that, where the amplitude of the beam deflection in the second direction (OY) can be at most equal to a predetermined value ($L_Y$), comparison means (109) produce a first signal ($S_7$) when the difference ($Y - Y_T$) between the ordinate address (Y) of the reference point associated with the next elementary image to be marked and the position ($Y_T$) of the target in the second direction (OY) with respect to a fixed reference connected with the beam generating source is less than the predetermined value ($L_Y$), and a second signal ($S_8$) complementary to the first signal when the difference exceeds this value.

**Ansprüche**

1. Vorrichtung zum programmierten Zeichnen von Figuren verschiedener Formen durch Bombardierung eines Ziels mit einem Teilchenbündel einstellbaren Querschnitts, das von einer Teilchenquelle (100) erzeugt wird, wobei die Figuren zusammengesetzt sind aus Elementarbildern ($R_1$ bis $R_5$) variabler Formen, die jeweils einem Bezugspunkt zugeordnet sind, der durch ein Abszissen- und Ordinaten-Adressenpaar in einem rechtwinkligen Bezugsachsensystem (OXY) identifizierbar ist ; wobei die Vorrichtung einen Schrittmotor (101) umfaßt, der eine Verschiebung des Ziels in einer ersten Richtung parallel zur Abszissenachse (OX), so daß dem Aufprall des Teilchenbündels nacheinander Teile des Zieles während Zeitintervallen ausgesetzt sind, in denen es in dieser Richtung unbewegt ist, und einen Motor (102) umfaßt, der eine kontinuierliche Verschiebung des Zieles in einer zweiten, zur Ordinatenachse (OY) parallelen Richtung bewirkt ; wobei die Vorrichtung dadurch gekennzeichnet ist, daß sie elektronische Ablenkmittel umfaßt, zur Ablenkung des Teilchenbündels derart, daß die Relativbewegung des Bündels in bezug auf das Ziel in der zweiten Richtung (OY) während einer Zeitspanne ($\theta_3 - \theta_2$) annulliert wird, die wenigstens gleich der Zeit ist, die für das Aufzeichnen wenigstens eines Elementarbildes ($R_2$, $R_3$, $R_4$) erforderlich ist, dessen Bezugspunkt eine bestimmte Ordinatenadresse ($Y_2$) hat.

2. Vorrichtung nach Anspruch 1, dadurch gekennzeichnet, daß die Teilchen Elektronen sind.

3. Vorrichtung nach Anspruch 2, dadurch gekennzeichnet, daß elektrisch steuerbare Mittel (2, 4) vorgesehen sind, um den einstellbaren Querschnitt des Bündels so zu bestimmen, daß er an die Form des aufzuzeichnenden Elementarbildes angepaßt ist, und um seine Aufprallzone auf dem Ziel (10) zu bestimmen und auf diese Weise bei jedem Aufprall ein Elementarbild zu erzeugen.

4. Vorrichtung nach Anspruch 2, dadurch gekennzeichnet, daß ein Rechner den Programmablauf gewährleistet, wobei dieser Rechner einen ersten Ausgang ($S_3$) und einen zweiten Ausgang ($S_2$) aufweist, von denen der erste die Ordinatenadressen der Bezugspunkte jedes Elementarbildes und der zweite eine Gruppe von Ziffern (I, h, θ) abgibt, welche die Form jedes Elementarbildes definieren, wobei ein erster und ein zweiter Digital/Analog- Umsetzer (CNAX, CNAY) diese Ziffern in elektrische Signale umsetzen, welche an die Mittel zur Steuerung des Bündels (X, Y) angelegt sind.

5. Vorrichtung nach Anspruch 4, dadurch gekennzeichnet, daß eine Gruppe von monostabilen Vorrichtungen (111, 112) die Ein- und Abschaltung des Bündels zwischen dem Aufzeichnen von zwei Elementarbildern gewährleistet, wobei die Einschaltdauer (T) unabhängig von den Abmessungen des aufzuzeichnenden Elementarbildes konstant ist und jede Ausschaltdauer ein ganzes Vielfaches einer vorbestimmten Zeit ist, welche die minimale Zeit (τ) für den Übergang von einer Einschaltperiode zur nächsten ist.

6. Vorrichtung nach Anspruch 5, dadurch gekennzeichnet, daß bei einer Ablenkamplitude des Bündels in der zweiten Richtung (OY), die höchstens gleich einem vorbestimmten Wert ($L_Y$) sein kann, Vergleichermittel (109) ein erstes Signal ($S_7$) erzeugen, wenn die Differenz ($Y - Y_T$) zwischen der Ordinatenadresse (Y) des dem nächsten aufzuzeichnenden Elementarbild zugeordneten Bezugspunktes und der Position ($Y_T$) des Ziels in der zweiten Richtung (OY) in bezug auf eine feste Bezugsgröße, die mit der das Bündel erzeugenden Quelle verbunden ist, geringer ist als der vorbestimmte Wert ($L_Y$), und ein zweites, zu dem ersten Signal komplementäres Signal ($S_8$) erzeugt, wenn die Differenz größer als dieser Wert ist⁺

0 002 409

Fig. 1

Fig. 2

_103_

Y

X

_101_

_102_

Fig. 3

FIG. 4

FIG. 5

FIG. 6

FIG. 7